# EUROPEAN PATENT SPECIFICATION

(11) **EP 0 718 872 B1**
(45) Date of publication and mention of the grant of the patent: **20.01.1999**
(21) Application number: 95305651.2
(22) Date of filing: 14.08.1995
(51) Int. Cl.: H01L 21/302, B08B 3/04

(54) **Semiconductor substrate cleaning method**
Reinigungsverfahren für ein Halbleitersubstrat
Procédé de nettoyage de substrats semi-conducteurs

(30) Priority: 19.12.1994 JP 314392/94
(43) Date of publication of application: 26.06.1996
(73) Proprietor: FUJITSU LIMITED, Kawasaki-shi, Kanagawa 211 (JP)
(72) Inventor: Hayami, Yuka, c/o Fujitsu Limited, Kawasaka-shi, Kanagawa 211 (JP); Suzuki, Miki T., c/o Fujitsu Limited, Kawasaka-shi, Kanagawa 211 (JP); Ogawa, Hiroki, c/o Fujitsu Limited, Kawasaki-shi, Kanagawa 211 (JP)
(74) Representative: Silverman, Warren

(56) References cited:
- DE-A- 4 340 589
- JP-A- 6 053 201
- JOURNAL OF THE ELECTRO- CHEMICAL SOCIETY, vol. 140, no. 3, March 1993 T. OHMI et al. "Native Oxide Growth and Organic Impurity Removal on Si Surface with Ozone-Injected Ultrapure Water" pages 804-810
- PATENT ABSTRACTS OF JAPAN, unexamined applications, E section, vol. 16, no. 435, September 10, 1992 THE PATENT OFFICE JAPANESE GOVERNMENT page 20 E 1263; & JP-A-04 151 835 (SHIMADA)
- SOVIET INVENTIONS ILLUSTRATED, EL section, week E 15, 1982, May 26, DERWENT PUBLICATIONS LTD., London; & SU-A-843 029
- PATENT ABSTRACTS OF JAPAN, unexamined applications, E section, vol. 14, no. 425, September 13, 1990 THE PATENT OFFICE JAPANESE GOVERNMENT page 77 E 977; & JP-A-02 164 035 (NEC)

## Description

The present invention relates to a silicon semiconductor substrate cleaning method for use in a fabrication process for a semiconductor device, and to a semiconductor device fabrication method using the cleaning method.

Increasingly, the semiconductor device fabrication industry has come to need to produce semiconductor integrated circuits of high quality both efficiently and without lowering throughputs and yields. To this end, more effective silicon semiconductor substrate (hereinafter generally termed "silicon substrate") cleaning methods are being developed.

In the conventional generally used silicon substrate cleaning method, chemical cleaning by immersion in many kinds of chemicals and water cleaning are repeated so as to remove contaminants, such as particles, metallic contaminants, organic substances, etc.

In the usual conventional silicon substrate cleaning methods, the more the chemical treatment steps the greater the cleaning time. This results in lower throughputs and has been a problem.

Moreover, when using a cleaning chemical of high viscosity, the usual water cleaning carried out subsequently cannot fully remove the treatment chemical. This, too, lowers product yields and has been also a problem.

Finally, of note, are the disclosures of JP-A-0 415 835 and JP-A-0 605 3201. As disclosed in Patent Abstracts of Japan for these publications, it is known in respect of the former to use low dissolved oxygen pure water in rinsing of already cleaned silicon substrates to prevent oxide formation and, in respect of the latter to use such water in removal of water soluble oxides from III-V compound semiconductor substrates. The present inventors have been concerned with removal of water insoluble oxides from silicon substrates.

An object of the present invention is to provide a silicon substrate cleaning method which can effectively remove contaminants and residual chemicals without increasing the number of chemical treatment steps and/or enable a semiconductor device of high quality to be fabricated after use of the silicon substrate cleaning method without lowering product yields.

According to the present invention, there is provided a method of cleaning a silicon substrate having an oxide film thereon, whereby said oxide film is removed by immersing the silicon substrate in pure water having a dissolved-oxygen concentration of not more than 220 ppb at ambient temperature, the water having a temperature above 60°C and being under an atmosphere which controls the oxygen concentration to maintain said dissolved oxygen concentration in the pure water.

The above-described silicon substrate cleaning method, is preferably carried out under am atmosphere shielded from the ambient atmosphere so that the dissolved oxygen concentration in the pure water is maintained as aforesaid.

When carrying out the above-described silicon substrate cleaning method, it is preferable that the silicon substrate is immersed in the pure water for at least 10 minutes. The pure water itself is preferably at a temperature of at least 80°C, more preferably at least 90°C.

In a preferred embodiment of the invention the above-described silicon substrate cleaning method is carried out with the temperature of the pure water and the time during which the semiconductor substrate is immersed in the pure water such that, after the cleaning, a contact angle of above 70° is formed between the surface of the pure water and the silicon substrate.

The above-described silicon substrate cleaning method serves to remove oxide film on the surface of the semiconductor substrate. This may result from immersing the silicon substrate when the silicon substrate in a chemical solution. A chemical solution which gives rise to surface oxide formation on the silicon substrate is when the silicon substrate immersed therein is preferably a mixture of ammonium hydroxide, hydrogen peroxide and pure water. Alternatively, the method of this invention may be applied to removal of native oxide films formed on the surface of the silicon substrate as a result of exposure of the silicon substrate to an oxygen-containing atmosphere, or resulting from immersing the silicon substrate in pure water having a higher dissolved oxygen concentration than said pure water.

The above-described method may be utilised in a semiconductor device fabrication method which includes a step of cleaning surfaces of silicon substrates.

In summary, thus, in the practice of this invention, silicon substrates having surface oxide films are immersed in pure water having a dissolved oxygen concentration of not more than 200 ppb at ambient temperature and heated to a temperature above 60°C, under an atmosphere which controls the dissolved oxygen concentration to maintain such low dissolved oxygen concentration. In this way, the oxide film on the surfaces of the substrates is etched away. As a result, contaminants and residual chemicals can be effectively removed without adding any chemical treating step. The cleaning can be effective without increasing the number of chemicals, and improved throughputs can be obtained in the cleaning step.

For a better understanding of the invention, and to show how the same can be carried into effect, reference will now be made, by way of example only, to the accompanying drawings, wherein:-
FIG. 1 shows a diagrammatic view of silicon substrate cleaning equipment for use in a method embodying the present invention;
FIG. 2 sets out graphs of relationships between the amount of adsorbed metal on silicon substrates to be cleaned by a method embodying the present invention, and dissolved oxygen concentration in cleaning water;
FIG. 3 sets out graphs of relationships between amounts of adsorbed metal on silicon substrates cleaned by a cleaning method embodying the present invention, and treatment temperatures;
FIG. 4 sets out graphs of relationships between amounts of adsorbed metal on silicon substrates cleaned by a semiconductor substrate cleaning method embodying the present invention, and treatment time;
FIG. 5 sets out a graph indicating the depth profile of the contaminant Al of a silicon substrate prepared by a method embodying the present invention, the depth profile values being measured by XPS;
FIG. 6A sets out a graph indicating the result of TRXF measurements carried out on contaminated silicon substrates prepared in a method embodying the present invention;
FIG. 6B is a graph to be considered in achieving an understanding of the significance of FIG. 6A;
FIG. 7 is a graph showing the relationship between contact angle of water with the silicon substrates cleaned by a silicon substrate cleaning method embodying the present invention, and treatment temperatures;
FIG. 8 shows FT-IR RAS spectra measured on a silicon substrate cleaned by a cleaning method embodying the present invention, before and after immersion in pure water having a relatively low dissolved oxygen concentration;
FIG. 9 is a graph showing the relationship between contact angles of water with silicon substrates cleaned by a cleaning method embodying the present invention, and treatment time;
FIG. 10 shows FT-IR RAS spectra measured on a silicon substrate cleaned by a cleaning method embodying the present invention, before and after immersion in pure water having a relatively low dissolved oxygen concentration;
FIG. 11 is a graph showing residual sulfuric acid ion amounts on silicon substrates cleaned by a cleaning method embodying the present invention;
FIG. 12 is a schematic view of a first form of silicon substrate cleaning equipment for use when carrying out the method of the present invention;
FIG. 13 is a schematic view of a second form of silicon substrate cleaning equipment for use when carrying out the method of the present invention; and
FIG. 14 shows a schematic view of a third form of silicon substrate cleaning equipment for use when carrying out the method of the present invention.

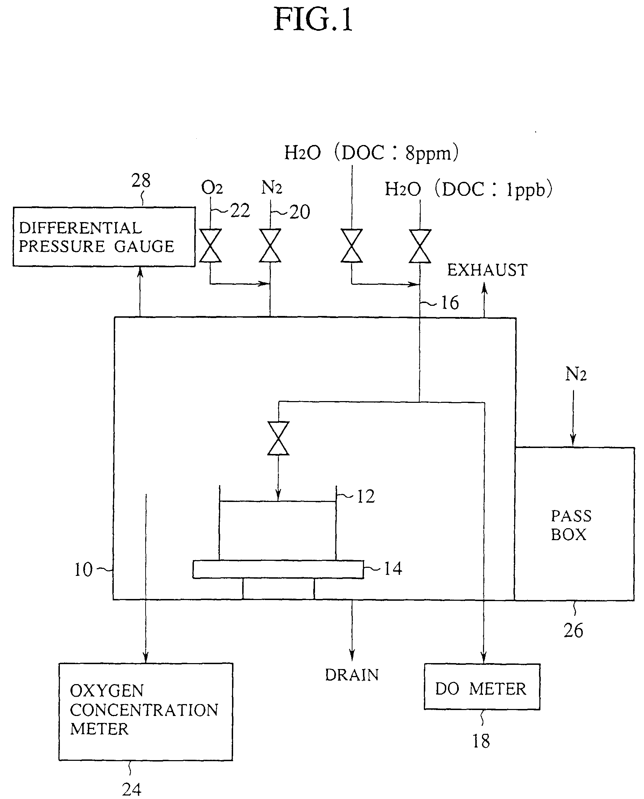

A silicon substrate cleaning method embodying the present invention, and silicon substrate cleaning equipment in which it is to be used, will be explained with reference to FIGs. 1 to 14. First the structure of the cleaning equipment used in the present embodiment will be explained.

FIG. 1 is a diagrammatic view of silicon substrate cleaning equipment to be used in carrying out the method of the present invention. The cleaning equipment is enclosed by a housing 10 so that the inside of the cleaning equipment is shielded from the outside air. In the box 10 there are provided a pure water bath 12 for cleaning silicon substrates, and a heater 14 which heats a cleaning liquid to be fed into the pure water bath 12. The pure water bath 12 has a pure water feed pipe 16 which supplies pure water thereto. The pure water feed pipe 16 is connected to a DO (dissolved oxygen) meter which detects dissolved oxygen concentration in the pure water to be supplied to the pure water bath 12.

Outside the box 10, there are provided a differential pressure gauge 28 which measures pressure differences between the outside of the housing and the inside of the housing 10, a nitrogen feed pipe 20 and an oxygen feed pipe 22, so that the conditions in the inside of the housing can be controlled. In the illustrated arrangement, oxygen concentrations in the housing 10 are monitored by an oxygen concentration meter 24 and are controlled to be below 25 ppm at 25°C.

In this way, it is possible to ensure that water is maintained at a <200 ppb dissolved oxygen content to enable the conditions in the equipment to be controlled in turn. Otherwise, unless appropriate measures are taken when pure water having a low dissolved oxygen content is left exposed to the ambient atmosphere, oxygen in the atmospheric air dissolves in the pure water and the dissolved oxygen concentration cannot be kept low.

The housing 10 has an external chamber 26 which prevents the external atmosphere from coming into the housing 10 when silicon substrates are being loaded into the housing 10. When silicon substrates are loaded into the housing 10, they are first temporarily supplied to the chamber 26, and the atmosphere in the chamber 26 is replaced by an inert gas atmosphere, e.g., nitrogen. Only then are the silicon substrates loaded into the housing 10.

The method of cleaning semiconductor substrates using the silicon substrate cleaning equipment will now be explained.

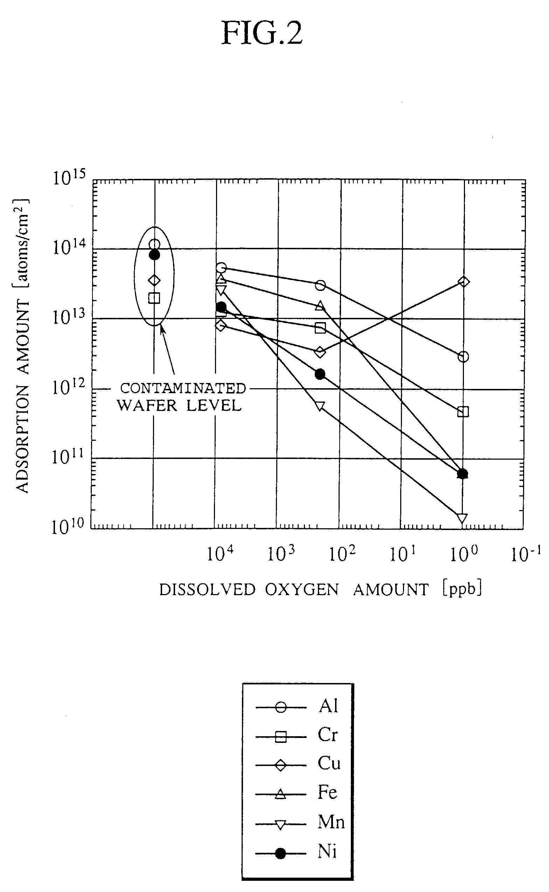

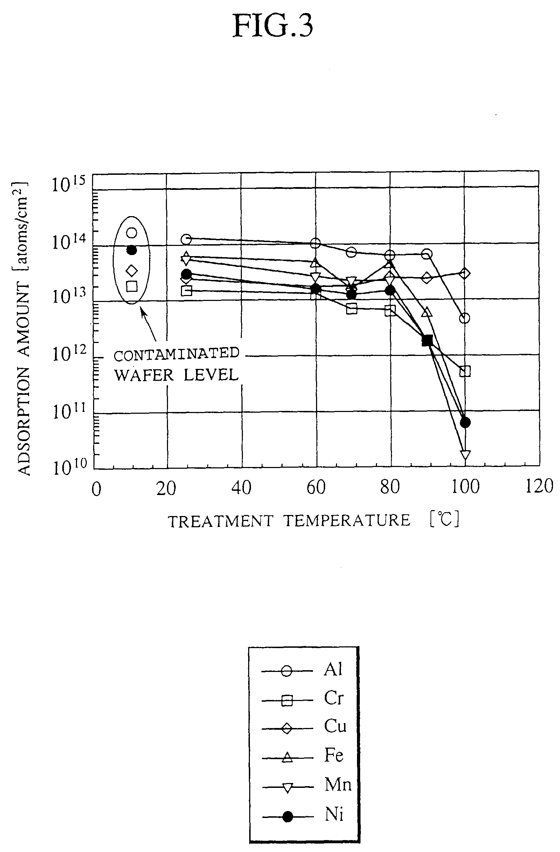

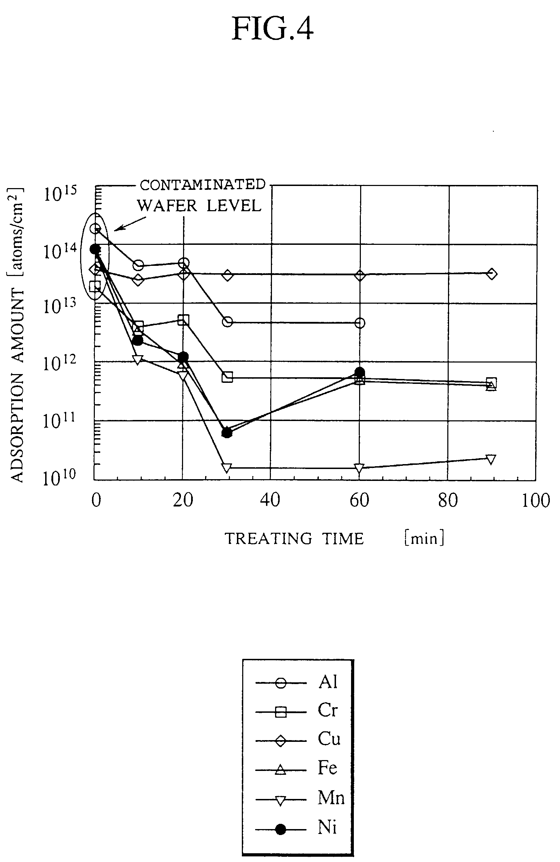

FIG. 2 shows the dependency of the amount of residual metallic contamination on the dissolved oxygen content of pure water. FIG. 3 shows the dependency of the amount of residual metallic contamination on the treatment temperature. FIG.4 shows the dependency of the amount of residual metallic contamination on the treatment time.

More specifically, FIG. 2 shows the relationship between dissolved oxygen concentration and the cleaning effect measured when silicon substrates were immersed in pure water having a temperature of 100°C for 30 minutes.

To confirm the effect of the cleaning on removal of metallic contaminants from the surfaces of silicon substrates, metallic contaminants were applied to the surfaces of the silicon substrates in a pretreatment step before the cleaning. Thus, p-type and n-type (100)-oriented silicon substrates having a resistivity about 10 Ω-cm were first treated with hydrogen fluoride to remove oxide films on the surfaces of the silicon substrates, and then immersed in an SC-1 solution added to an atomic absorption spectrometry standard solution containing Al, Cd, Co, Cr, Cu, Fe, Mg, Mn and Ni to achieve the chemical treatment of the substrates.

As shown in Figure 2, metallic contaminant amounts adsorbed on the surfaces of the silicon substrate were decreased by the cleaning of the silicon substrate with the pure water. The contaminant removal effect increased as the dissolved oxygen concentration in the pure water was decreased to 200 ppb and then to 1 ppb. Especially when the dissolved oxygen concentration was decreased to 1 ppb, the effect was marked for all contaminants except Cu.

FIG. 3 shows the relationship between pure water temperature and the cleaning effect measured when dissolved oxygen concentration in the pure water was 1 ppb and the treatment time was 30 minutes.

As shown, when the treatment temperature is below about 60°C, the metallic contaminant removing effect does not change much with treatment temperature. However, when the treatment temperature is above 60°C, the effect on metallic contaminant removal was improved for all metals except Cu. The contaminant removing effect sharply increased when the treatment temperature rose to above 80°C. When the treatment temperature was raised above 90°C, the contaminant removing effect improved further and the amount of Al contaminant, whose removal had not increased much previously, decreased to below 1/10 of initial amount.

The relationship between treatment time and cleaning effect with a dissolved oxygen concentration in the pure water set at 1 ppb and a treatment temperature set at 100°C is shown in FIG. 4.

Here, the adsorption amounts of metallic contaminants except Cu steadily decreased in the first 10 minutes of the treatment and decreased further with further increases in the immersion time. However, after 30 minutes, the adsorption amounts of contaminants did not decrease further and thereafter no substantial changes took place in the adsorbed amounts. Thus, the removal of metallic contaminants by the use of low dissolved-oxygen pure water is considered to reach equilibrium.

From the foregoing, it can be seen that metallic contaminants can be removed by the use of low dissolved-oxygen pure water. The mechanism of this phenomenon will be explained below.

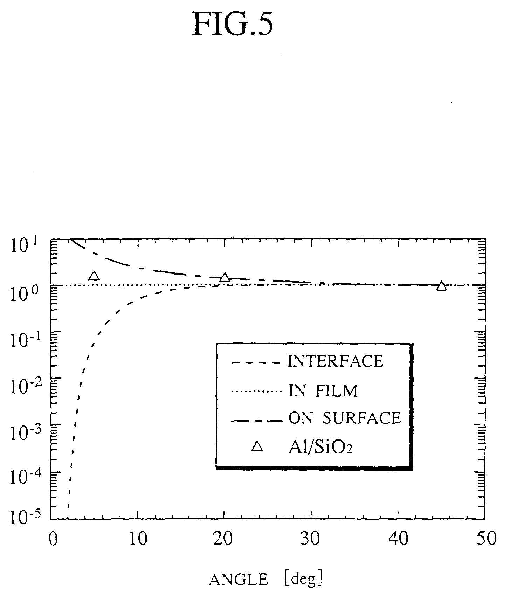

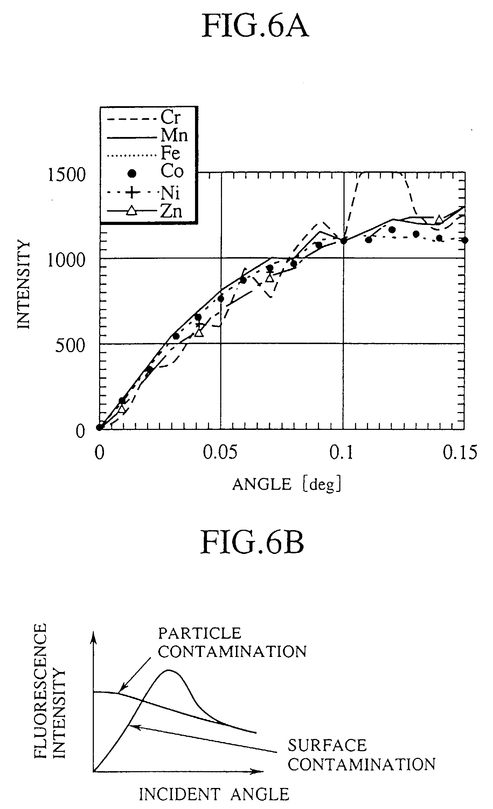

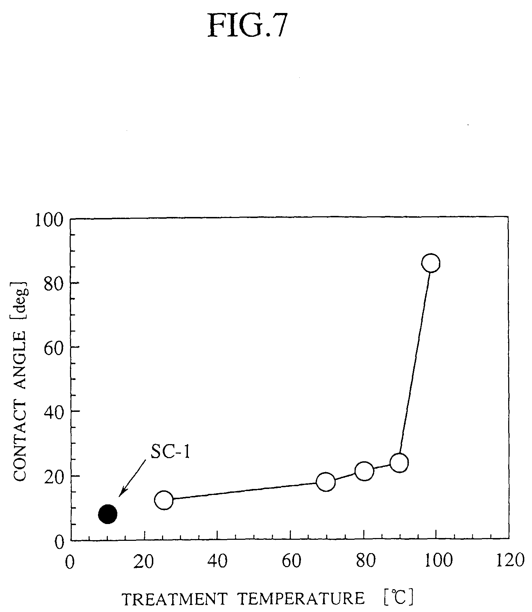

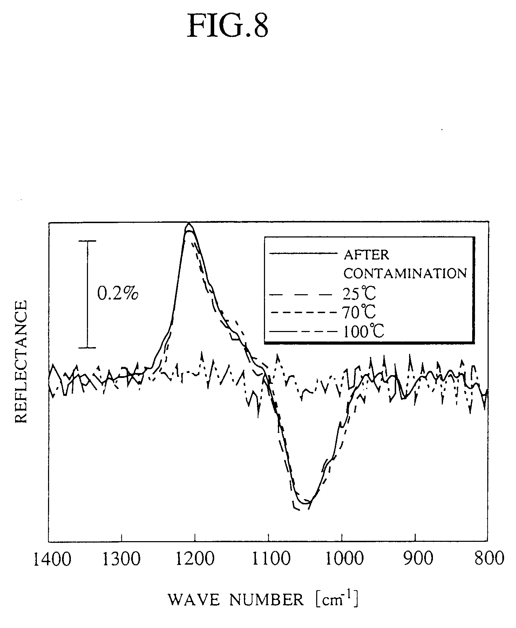

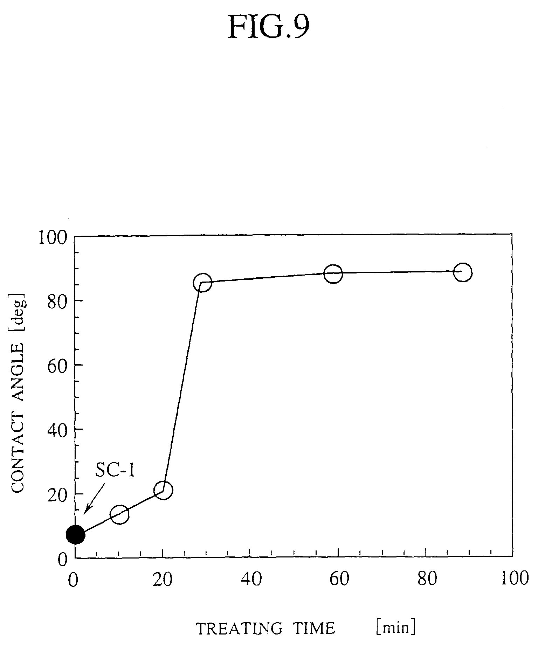

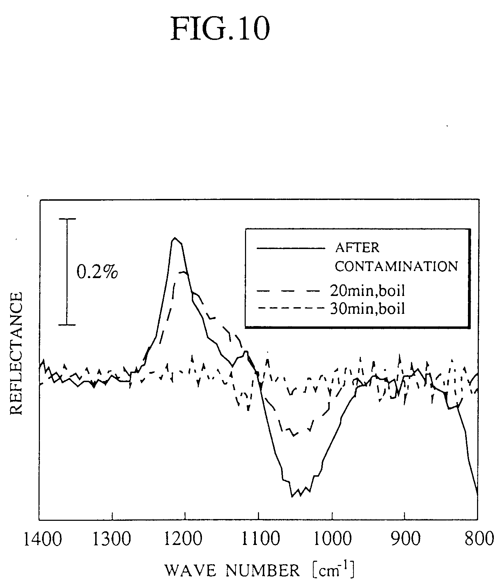

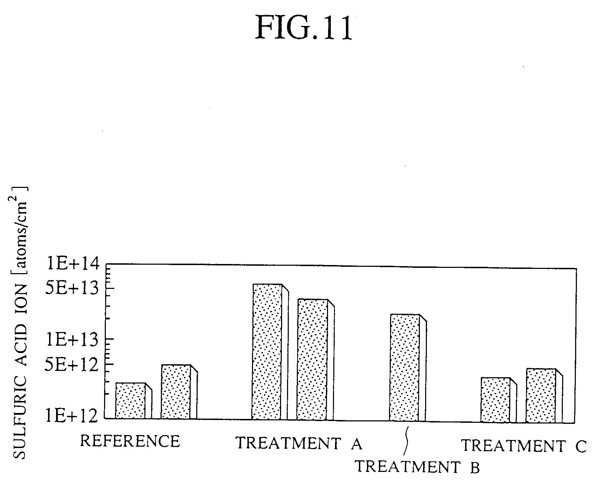

FIG. 5 shows the depth profile of the contaminant Al on silicon substrates processed in accordance with the method of this invention as measured by XPS (X-ray photoelectron spectroscopy). FIG. 6A shows the result of TRXF (total reflection X-ray fluorescence analysis) observation on the contaminated semiconductor substrates. FIG. 6B assists in explaining FIG. 6A. FIG. 7 is a graph showing the relationship between the contact angle between water and the cleaned silicon substrate and treatment temperatures. FIG. 8 shows the change in the FT-IR RAS spectra after immersion in pure water having a lower dissolved oxygen concentration. FIG. 9 is a graph showing the relationship between contact angles between water and the cleaned semiconductor substrates and treatment temperatures. FIG. 10 shows the change in the FT-IR RAS spectra after immersion in pure water having a lower dissolved oxygen concentration. FIG. 11 is a graph showing amounts of residual sulfuric acid ions on the cleaned silicon substrates.

Firstly, measured depth profile values for metallic contaminants in the contaminated samples prepared by the present embodiment will be considered.

FIG. 5 shows the depth profile of the contaminant Al measured by XPS, at the surface of silicon substrates immediately after contamination. In FIG. 5, the dotted line indicates interfaces between oxide films and the silicon substrates, and the dot chain line indicates the surfaces of the oxide films. As shown, it is found that Al is present as metallic contaminant in the oxide films and near the surface of the silicon substrate.

FIG. 6A shows the result of TRXF observation on the surfaces of the silicon substrate immediately after contamination. FIG. 6B shows how metallic contamination has different peak positions depending on particle contamination or molecular surface contamination. All the metallic contaminants have increasing intensities with increases of incident angles of X-rays, the metallic contaminants being present in molecular states.

Based on this result, it has been found that metallic contaminants on silicon substrates are not present as metal particles. Rather, the metals were in the oxide films or were adhered to the surfaces of the oxide films. Hence, when the metallic contaminants are removed by the use of low dissolved-oxygen pure water, chemical state and surface morphology of the silicon substrates may be affected.

FIG. 7 shows the relationship between treatment temperature and contact angle of water with the wafer surfaces for a dissolved oxygen concentration in the pure water set at 1 ppb and with treatment time set at 30 minutes.

As can be seen, before the treatment with the low dissolved oxygen pure water, the surfaces of the silicon substrates are hydrophilic because of grown oxide films, i.e., they have small contact angles with water (indicated by ● in FIG. 7). On treatment with the low dissolved-oxygen pure water, contact angles gradually increased with higher treatment temperatures. The changes were small at temperatures below 90°C and the semiconductor substrate surfaces remained hydrophilic. However, when the treatment temperature was above 100°C, contact angles greatly increased and the silicon substrate surfaces became hydrophobic.

The surface state of the silicon substrates at this time were estimated by FT-IR. As shown in FIG. 8, it was found that peak amounts of Si-O bonds observed at treatment temperatures below 70°C disappeared at a 100°C treatment temperature, and oxide films were removed.

With a dissolved oxygen concentration in the pure water set to 1 ppb and with a treatment temperature set at 100°C (FIG. 9), the value of the contact angle dramatically increases on immersion for more than 30 minutes, and the silicon substrate surfaces became hydrophobic. The amounts of Si-O bonds were detected by FT-IR, and it was found that peaks were eliminated in the 30 minute-treatment and oxide films were removed (FIG. 10).

As described above, when the dissolved oxygen concentration in the pure water was set to 1 ppb, and the treatment time was set at 30 minutes, the amounts of metals absorbed on the silicon substrate surfaces were greatly decreased. Based on these facts, the change in the silicon substrate surfaces from hydrophilic to hydrophobic is considered to be due to the oxide films on the silicon substrate surfaces being removed. At the same time, the metallic contaminants absorbed on the semiconductor substrate surfaces were removed. The equilibrium stage in the removal of contaminants as seen FIG. 4 is considered to be due to the oxide films having all been removed.

Hitherto herein, only the effect of removing metallic contaminants has been evaluated. However, organic impurities, fine particles, etc. adhered to oxide films can generally be removed by techniques employable for the oxide films. The effect of removing residual chemical after chemical treatment as aforesaid will now be explained.

FIG. 11 shows the amount of residual sulfuric acid ions after the silicon substrates have been immersed in a mixture of hydrogen peroxide and sulfuric acid and then cleaned with various kinds of pure water. In FIG. 11, Treatment A is a treatment with 8 ppb dissolved-oxygen concentration in 25°C pure water after a chemical treatment. Treatment B is a treatment with 1 ppb dissolved-oxygen concentration in 25°C pure water. Treatment C is a treatment with 1 ppb dissolved-oxygen concentration in 100°C pure water after a chemical treatment. A reference wafer was treated with a mixed liquid of ammonium hydroxide and hydrogen peroxide, and next treated with nitric acid.

Treatment C can be seen to reduce the residual sulfuric acid ion density down to about 1/10 that achieved in treatments A and B. The sulfuric acid density was reduced substantially to the level of the residual sulfuric acid ion density of the reference wafer.

Just as described above in connection with removal of metal contaminants, when the silicon substrates are immersed in pure water heated to a temperature above 60°C in an atmosphere which allows the dissolved-oxygen concentration in the pure water to be maintained thereby to remove oxide films formed on the surfaces of the silicon, the method according to the present embodiment can be applied to cleaning of chemicals from the surfaces of silicon substrates by the use of pure water of a low dissolved-oxygen concentration. Accordingly, both contaminants and residual chemicals can be effectively removed without the need to employ chemical treatment steps.

The cleaning of silicon substrates by the use of pure water of low dissolved-oxygen concentration does not require chemicals of high viscosity. The surfaces of semiconductor substrates can be cleaned to remove completely residual chemicals.

Water cleaning with the above-described low dissolved-oxygen concentration pure water following a chemical treatment can effectively reduce residual chemicals in comparison with water cleaning with pure water having a dissolved oxygen concentration not controlled or in comparison with dissolved oxygen pure water at below 60°C.

The cleaning method can remove contaminants without residual chemicals, and semiconductor devices of high quality can be produced without lowering product yields.

In the above-described embodiment, cleaning of so-called chemical oxide films formed by SC-1 treatment from silicon substrates has been explained. Cleaning of oxide films on the surfaces of silicon substrates may be carried out with low dissolved-oxygen pure water to remove native oxide films formed by leaving silicon substrates in an atmosphere containing oxygen or immersing the silicon substrates in pure water with a higher dissolved-oxygen amount. For example, in pretreatments for forming films of electrode materials, cleaning is conducted with low dissolved-oxygen pure water for cleaning of the surfaces of silicon substrates concurrent with removal of native oxide films.

As described above, contaminants adhered to the surfaces of silicon substrates can be removed by immersing the substrates for more than 10 minutes in pure water having a below 200 ppb level of dissolved oxygen concentration and which has been heated to above 60°C. It is preferred that the precise conditions employed are optimized in accordance with equipment used.

For example, the temperature of the pure water and the period of time during which silicon substrates are immersed are set so that the contact angle formed between the pure water and the silicon substrates, with no oxide film formed thereon, all oxide film having been removed, is above 70° after cleaning the silicon substrate. Thus, contaminants on the surfaces of silicon substrates can be effectively removed.

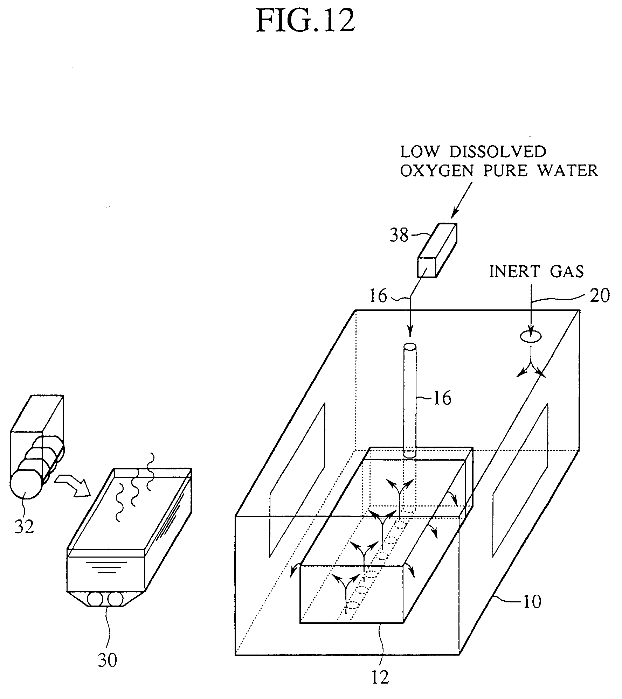

Next, three variants of the method according to the present invention will now be explained with reference to FIGs. 12, 13 and 14.

In the fabrication of a semiconductor device, usually chemical treatments and water cleaning are repeated to remove fine particles, metallic contaminants, organic substances, etc. To this end, a chemical bath for treatments with chemicals and a pure water bath for the water cleaning are needed. As shown in FIG. 12, silicon substrate cleaning equipment is constituted by a chemical bath 30 and a pure water bath 12, the latter being provided in the closed interior of a housing 10 or the like disposed in a usual draft chamber. Silicon substrates 32 are subjected to a chemical treatment in the chemical bath 30, then loaded into the closed unit in which an atmosphere of adjusted oxygen concentration is established, and are subjected to water cleaning by low dissolved-oxygen pure water in the pure water bath 12.

When the chemically treated silicon substrates are loaded into the closed unit, it is preferred to sustain a gas atmosphere in the closed unit. To this end a chamber 26 is provided between the closed unit and the outside atmosphere as shown in FIG. 1. In this way, the cleaning can be conducted without disturbing the gas atmosphere in the closed unit.

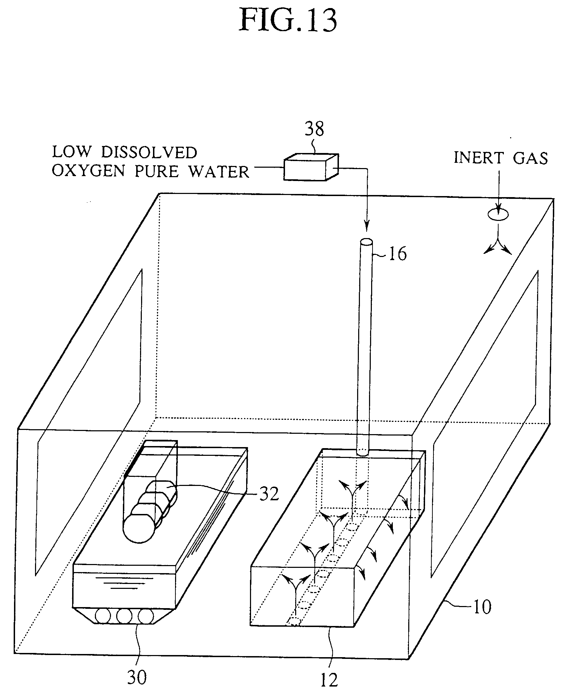

As shown in FIG. 13, it is possible that the chemical bath 30 and the pure water bath 12 be disposed in the same closed unit under an atmosphere having an adjusted oxygen concentration.

In such arrangement the atmosphere in the housing 10 was controlled so that the oxygen concentration was below 25 ppm at 25°C and atmospheric pressure. It is preferred, however, to control the oxygen concentration in the atmosphere used so that the oxygen concentration in the closed unit can maintain dissolved oxygen concentration in the pure water at a desired low level. Thus, the oxygen concentration in the atmosphere is controlled so as to satisfy Henry's law.

The pure water bath is provided in the closed unit to prevent outside oxygen from dissolving in the low dissolved-oxygen pure water used for obtaining a high cleaning effect. It is not essential to have the pure water bath within the closed unit as long as the cleaning equipment is such that the low dissolved-oxygen pure water is kept out of contact with outside oxygen.

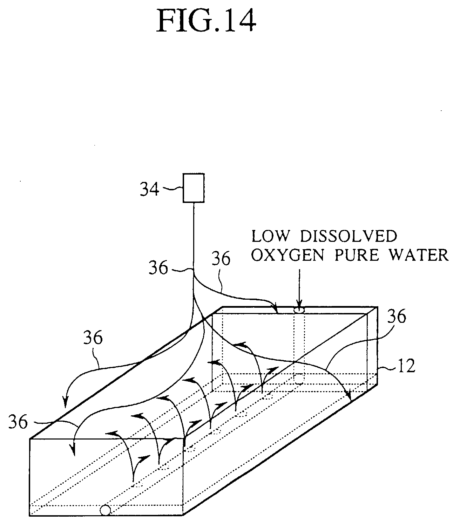

As can be seen in FIG. 14, an inert gas injection port 34 (there may be more than one) is provided above the pure water bath 12, so that inert gas streams are generated which cover the surface of the pure water bath 12 with the inert gas are generated. Outside air does not dissolve in the low dissolved-oxygen pure water, and silicon substrates can be cleaned with the dissolved oxygen concentration kept low.

Otherwise, for example, inert gas injection ports are provided in the walls of the pure water bath, or near the pure water bath and above the surface of the pure water, and inert gas exhaust ports are provided opposed to the injection ports across the pure water bath, so that the inert gas is caused to flow horizontally.

In the above-described arrangement of Figure 1, the low dissolved-oxygen pure water is heated by the heater 14 provided in the pure water bath 12. As shown in FIGs. 12 and 13, pure water may be heated on passage through heating means 38 before being fed into the cleaning equipment. In this case, overflow rinse, etc. with the low dissolved oxygen pure water is possible. This ensures that removed contaminants do not remain in the pure water bath 12 and may enhance the contaminant removing effect.

## Claims

1. A method of cleaning a silicon substrate having an oxide film thereon, whereby said oxide film is removed by immersing the silicon substrate in pure water having a dissolved-oxygen concentration of not more than 200 ppb at ambient temperature, the water having a temperature above 60°C and being under an atmosphere which controls the oxygen concentration to maintain said dissolved oxygen concentration in the pure water.

2. The method according to claim 1, which is carried out under an atmosphere which is shielded from the ambient atmosphere.

3. The method according to claim 1 or 2, wherein the silicon substrate is immersed in said pure water for at least 10 minutes.

4. The method according to any preceding claim, wherein the pure water is at a temperature at least 80°C, preferably at least 90°C.

5. The method according to any preceding claim, wherein the silicon substrate is cleaned so that, after the cleaning, a contact angle of above 70° is formed between the surface of said pure water and the silicon substrate.

6. The method according to any preceding claim, wherein the oxide film on the surface of the silicon substrate is chemical oxide film formed by immersing the silicon substrate in a chemical solution.

7. The method according to claim 6, wherein the chemical solution is a mixture of ammonium hydroxide, hydrogen peroxide and pure water.

8. The method according to any preceding claim, wherein oxide film on the surface of the silicon substrate is native oxide film formed as a result of exposure of the silicon substrate to an oxygen-containing atmosphere, or resulting from immersing the silicon substrate in pure water having a higher dissolved oxygen concentration than said pure water.

9. A semiconductor device fabrication method comprising a step whereby a surface of a silicon substrate is cleaned by the method of any preceding claim.

## Patentansprüche

1. Verfahren zum Reinigen eines Siliziumsubstrats mit einem darauf vorhandenen Oxidfilm, durch das der Oxidfilm entfernt wird, indem das Siliziumsubstrat in reines Wasser mit einer Konzentration an gelöstem Sauerstoff von nicht mehr als 200 ppb bei Umgebungstemperatur eingetaucht wird, wobei das Wasser eine Temperatur von über 60°C hat und sich unter einer Atmosphäre befindet, welche die Sauerstoffkonzentration steuert, um die genannte Konzentration an gelöstem Sauerstoff in dem reinen Wasser aufrecht zu erhalten.

2. Verfahren nach Anspruch 1, welches unter einer Atmosphäre durchgeführt wird, die gegenüber der Umgebungsatmosphäre abgeschirmt ist.

3. Verfahren nach Anspruch 1 oder 2, bei dem das Siliziumsubstrat in das reine Wasser für wenigstens 10 Minuten eingetaucht wird.

4. Verfahren nach irgendeinem der vorhergehenden Ansprüche, bei dem das reine Wasser eine Temperatur von wenigstens 80°C, bevorzugt wenigstens 90°C hat.

5. Verfahren nach irgendeinem der vorhergehenden Ansprüche, bei dem das Siliziumsubstrat derart gereinigt wird, daß nach dem Reinigungsvorgang ein Berührungswinkel von über 70° zwischen der Oberfläche des reinen Wassers und dem Siliziumsubstrat gebildet wird.

6. Verfahren nach irgendeinem der vorhergehenden Ansprüche, bei dem der Oxidfilm auf der Oberfläche des Siliziumsubstrats aus einem chemischen Oxidfilm besteht, der durch das Eintauchen des Siliziumsubstrats in eine chemische Lösung gebildet wurde.

7. Verfahren nach Anspruch 6, bei dem die chemische Lösung aus einer Mischung aus Ammoniumhydroxid, Wasserstoffperoxid und reinem Wasser besteht.

8. Verfahren nach irgendeinem der vorhergehenden Ansprüche, bei dem der Oxidfilm auf der Oberfläche des Siliziumsubstrats aus einem ursprünglichen Oxidfilm besteht, der als ein Ergebnis des Aussetzens des Siliziumsubstrats einer Sauerstoff enthaltenden Atmosphäre gebildet wurde, oder aus dem Eintauchen des Siliziumsubstrats in reines Wasser resultierte mit einer Konzentration an gelöstem Sauerstoff, die höher lag als diejenige des reinen Wassers.

9. Herstellungsverfahren für eine Halbleitervorrichtung, mit einem Schritt, durch den eine Oberfläche eines Siliziumsubstrats durch das Verfahren nach irgendeinem der vorhergehenden Ansprüche gereinigt wird.

## Revendications

1. Procédé de nettoyage d'un substrat de silicium ayant un film d'oxyde sur celui-ci, par lequel ladite couche d'oxyde est enlevée par immersion du substrat de silicium dans de l'eau pure ayant une concentration d'oxygène dissous pas plus que 200 ppb à température ambiante, l'eau ayant une température au-dessus de 60°C et étant sous une atmosphère qui commande la concentration d'oxygène pour maintenir ladite concentration d'oxygène dissous dans l'eau pure.

2. Procédé selon la revendication 1, qui est réalisé sous une atmosphère qui est protégée de l'atmosphère ambiante.

3. Procédé selon la revendication 1 ou 2, dans lequel le substrat de silicium est immergé dans ladite eau pure pendant au moins 10 minutes.

4. Procédé selon l'une quelconque des revendications précédentes, dans lequel l'eau pure est à une température d'au moins 80°C, préférablement au moins 90°C.

5. Procédé selon l'une quelconque des revendications précédentes, dans lequel le substrat de silicium est nettoyé pour que, après le nettoyage, l'angle de contact au-dessus de 70°C soit formé entre la surface de ladite eau pure et le substrat de silicium.

6. Procédé selon l'une quelconque des revendications précédentes, dans lequel la couche d'oxyde sur la surface du substrat de silicium est un film d'oxyde chimique formé en immergeant le substrat de silicium dans une solution chimique.

7. Procédé selon la revendication 6, dans lequel la solution chimique est un mélange d'hydroxyde d'ammonium, de peroxyde d'hydrogène et d'eau pure.

8. Procédé selon l'une quelconque des revendications précédentes, dans lequel un film d'oxyde sur la surface du substrat de silicium est une couche d'oxyde native formée comme un résultat de l'exposition du substrat de silicium à une atmosphère contenant de l'oxygène, ou résultant de l'immersion du substrat de silicium dans de l'eau pure ayant une concentration d'oxygène dissous plus élevée que ladite eau pure.

9. Procédé de fabrication de dispositif semiconducteur comprenant une étape dans laquelle une surface d'un substrat de silicium est nettoyée par le procédé d'une quelconque des revendications précédentes.
